# EUROPEAN PATENT APPLICATION

(11) **EP 0 871 213 A2**
(43) Date of publication of application: **14.10.1998**
(21) Application number: 98103655.1
(22) Date of filing: 03.03.1998
(51) Int. Cl.: H01L 21/311, H01L 21/768

(54) **Method for producing vias having variable sidewall profile**

(30) Priority: 27.03.1997 US 826463
(71) Applicant: SIEMENS AKTIENGESELLSCHAFT, 80333 München (DE)
(72) Inventor: Hanebeck, Jochen, 01099 Dresden (DE)
(74) Representative: Patentanwälte Westphal,Buchner,Mussgnug,Neunert,Göhring

(57) **Abstract**

A via opening having a varying sidewall taper can be made by varying the proportion of polymers deposited on the sidewalls during the etch. For example, the proportion of a fluorine-containing etch gas and an inert carrier gas can be changed to etch smooth variably tapered vias in silicon oxide to ensure complete filling of the vias by a subsequently deposited layer of material.

## Description

This invention relates to a plasma etch process for forming vias in a semiconductor substrate. More particularly, this invention relates to a process for forming vias having variable sidewall profiles in a semiconductor substrate.

### BACKGROUND OF THE INVENTION

In the manufacture of semiconductor devices, a plurality of devices, such as transistors, are formed in the semiconductor substrate, e.g., a silicon wafer. These transistors are connected electrically by means of conductive metal lines, generally made of aluminum. Metal contacts are also deposited on the substrate to connect the devices to other devices or packages.

As the number of devices on a single substrate have been made smaller and closer together, and design rules made less than one micron and even less than 0.5 micron, more devices can be made on a single silicon wafer by making more than one layer of devices. A first group of devices is formed and electrically connected, and then a dielectric layer, such as of silicon oxide, is deposited thereover. Access to the first level of conductive lines and contacts must be made through the silicon oxide layer. Thus vias are formed in the silicon oxide layer over the preformed conductive metal lines and contacts. These vias are thereafter filled with a conductive metal such as aluminum. The filled vias provide a means of electrical connection to the underlying devices.

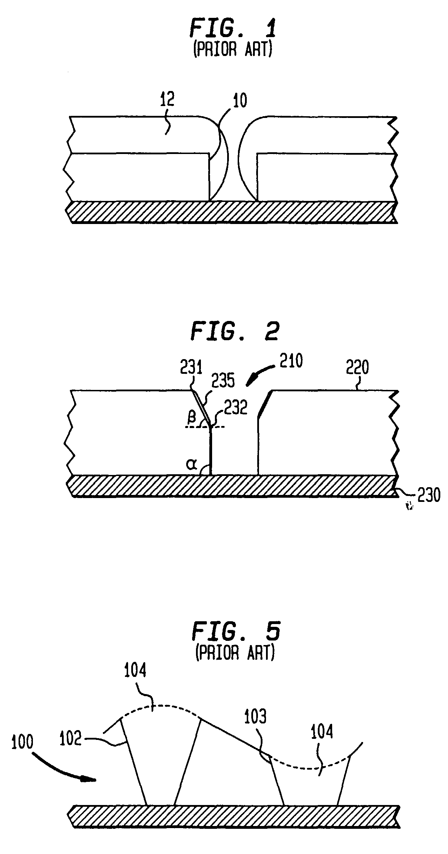

Aluminum is generally deposited by sputtering. As the vias become smaller and their aspect ratio becomes higher however, it is more difficult to fill the vias or openings uniformly. The sidewalls block incoming aluminum particles sputtered at any angle other than the vertical, so that the aluminum sputters more on the sidewalls than on the bottom of the opening. Eventually the aluminum on the sidewalls closes the opening and leaves a void at the bottom of the via, see Fig. 1, wherein an aluminum layer 12 is deposited in a via 10.

Attempts have been made to improve the filling capability by heating the aluminum to melt temperatures, but this may not be desirable because dopant ions already formed in the underlying devices may diffuse and change the electrical characteristics of the devices.

Attempts to improve aluminum filling by adding a wetting agent for aluminum to the sidewalls have only been marginally successful, and such a process requires another deposition step.

Other attempts have been made to taper the via openings so that they are wider at the top, thus improving the aluminum fill. The prior art methods generally provide some combination of tapered and straight sidewalls formed by a combination of isotropic and anisotropic etching.

For example, Meng et al, in US Patent 5,453,403 disclose forming straight walled openings partially through the dielectric layer using CF₄ and CHF₃, and then anisotropically etching with HF to widen the top of the via. A third sputter etch step with argon and CF₄ completes the etch at the bottom of the via to open the via to the underlying metal contact below. However, this process requires several steps and several processing chambers, reducing the throughput and economics of this process.

Sikora et al, US Patent 5,420,078, form a tapered or faceted opening first with an isotropic HF etch at the top of the via, and then continue with an anisotropic etch to form straight walled openings to the underlying conductor. This requires two chambers as well, one to perform the HF etch and another to perform the anisotropic etch.

Cheung et al, US Patent 5,354,386 disclose etching tapered vias in silicon oxide by alternately using a CF₄ anisotropic etch and a CF₄ + O₂ isotropic etch. By varying the oxygen content, the degree of taper of the via sidewalls is also varied. However, this method requires the use of oxygen, which is generally to be avoided in a plasma etch process including a fluorocarbon.

Thus a single step etch process that can form a tapered via opening, without requiring the use of oxygen in a single plasma etch chamber would be highly desirable.

### SUMMARY OF THE INVENTION

In accordance with the process of the invention, vias having a freely variable sidewall taper can be formed in a single plasma etch chamber. A high degree of freedom of the angle of the taper by varying the amount of polymer formation on the sidewall permits formation of vias having shallow sidewall taper openings at the top of a via, and a steeper sidewall taper at the bottom of a via, or vice versa. The vias can be tailored during the etch so that the vias can be completely filled with a conductive metal.

### BRIEF DESCRIPTION OF THE DRAWING

Fig. 1 is a schematic cross sectional view of an opening partially filled with sputtered aluminum using a prior art process.

Fig. 2 is an illustrative embodiment of an opening with tapered sidewalls.

Fig. 3 is a photomicrograph of a plasma etched opening made using the process of the invention.

Fig. 4 is a photomicrograph of another plasma etched opening made using the process of the invention.

Fig. 5 is a schematic cross sectional view of a plurality of openings made in a layer having variable thickness according to a prior art process.

### DETAILED DESCRIPTION OF THE INVENTION

The present invention relates to the fabrication of vias in a dielectric material, such as silicon oxide. Other dielectric materials, including doped or undoped silicate glass such as BSG or BPSG, are also useful. The vias comprises tapered sidewalls which facilitates the filling of the vias with a conductive material such as aluminum (Al). Other conductive material such as tungsten (W), copper (Cu), titanium (Ti), metal derivatives such as titanium silicide and titanium nitride, or other conventional material used to form conductive layers is also useful.

Fig. 2 shows an illustrative embodiment of the invention. As shown, a via 210 is formed in a dielectric layer 220 for interconnection to a conductive layer 230. The via comprises a tapered sidewall having an angle β at the top portion and an angle α at a lower portion. In accordance with the invention, the angles of the tapered sidewalls is varied without requiring additional etch chambers or additional clean steps, thus, reducing cost and raw process time (RPW).

In one embodiment, the vias are formed using conventional etch processes. For example, etching of dielectric material can be achieved using various conventional fluorocarbon etch chemistry that produce fluorine etch spaces. Some fluorocarbon etch chemistry includes, for example, CH₄ and CHF₃. Other fluorocarbon etch chemistry is also useful. Typically, the fluorocarbon is combined with other gas or gases such as argon. Preferably, the etch process is performed in a plasma etch chamber since plasma etching generally occurs at lower temperatures. Plasma etch chambers for fluorine-containing etchants are commercially available for carrying out the present process. Alternatively, reactive ion etching is also useful.

A by-product of fluorocarbon etch processes is polymer, which is deposited on the sidewalls of the vias. Polymer has a higher selectivity to the fluorine etch chemistry than the dielectric material. Thus, polymer formation is undesirable as it hinders the effectiveness of the etch process and may act as an etch stop. As such, the etch parameters are adjusted to reduce or minimize the formation of polymers.

However, the invention takes advantage of the polymer formation during the etch process. In accordance with the invention, a polymer layer 235 formed during the etch process is used to protect the dielectric material from being etched. In the beginning of the process, the polymer forms on sidewalls 231 of the via, protecting the dielectric material thereunder. As the etch process progresses, the polymer formation extends from the sidewalls toward the center 232 of the via at an angle, continuing to shield the dielectric material thereunder from the etch chemistry. Thus, the polymer is advantageously employed to form a via with a tapered sidewall.

In accordance with the invention, the angle (α or β) of the tapered sidewalls are varied by changing the rate at which the polymers are deposited on the sidewalls. The angle is inversely related to the rate of polymer growth. That is, faster polymer formation results in a smaller angel, producing sidewalls that are less steep. Conversely, slower polymer formation results in steeper sidewalls.

In one embodiment, the rate of polymer deposition is varied by varying the etch parameters, changing the angle in the tapered sidewalls. The etch parameters that affect polymer formation include, for example:
etch chemistry;
ratio of the etch gases;
chamber pressure during the etch;
cathode and chamber temperature during the etch; magnetic fields in the plasma etch
chamber; and
substrate backside pressure.

Chamber pressure has a direct relationship with the rate of polymer formation. As the pressure of the chamber increases, less sputtering occurs which results in an increase in polymer formation.

Cathode and chamber temperature have an inverse relationship to polymer formation. Increasing the temperature of either or both the cathode and the chamber decreases the sticking coefficient of the dielectric material. As a result, the rate of polymer formation is decreased.

The strength of the magnetic fields in the chamber has a direct relationship to the rate of polymer formation. An increase in magnetic field increases the ionization of the plasma, thereby increasing the rate of polymer formation.

The etch chemistry has an affect on the formation of polymers. In particular, polymer formation depends on the presence carbon (C) in the etch chemistry. During the etch process, the fluorocarbon etch chemistry including, for example, CF₄ and CHF₃, reacts and forms CF2 and a by-product. The CF₂, which is the polymer, is deposited onto the sidewalls of the dielectric material. Increasing the ratio of the fluorocarbon with respect to other gas or gases in the etch chemistry produces a larger quantity of polymers, thereby increasing the polymer deposition rate.

In accordance with the invention, a tapered sidewall profile is created by etching the dielectric material under conditions such that polymer deposits on the sidewalls. The angle or slope of the tapered sidewall profile depends on the polymer deposition rate. By varying process parameter or parameters that increase the polymer deposition rate, a tapered sidewall profile with relatively smaller slope (less steep) is produced. Decreasing the rate of polymer deposition, on the other hand, produces a steeper slope.

In one embodiment, a via with a variable tapered sidewall profile is formed. The via comprises a opening at the top that is wider than the opening at the bottom to facilitate filling with a conductive material. As such, the via comprises a tapered sidewall profile that is less steep at the top and more steep near the bottom so that it is almost vertical.

The via is formed by plasma etching with fluorocarbon etch chemistry. The etch parameters are adjusted such that polymer deposits sufficiently on the sidewalls of the via to effectively form a tapered profile. To form a more vertical sidewall profile, the etch parameters are adjusted such that polymer deposition is reduced or minimized, creating a more anisotropic etch.

Furthermore, the polymer layer deposited to form the tapered sidewall at the upper portion of the via is sufficiently thick to protect the profile from being altered during the formation of the more vertical sidewall at the bottom. Of course, those skilled in the art will appreciate that the thickness of the polymer depends on the total thickness of the dielectric layer in which the via is formed and also the selectivity of the etch to the polymer with respect to the dielectric material.

Generally, the thickness of the polymer layer is at least about 1/(selectively to the polymer) x T, where T is equal to about the thickness of the remaining portion of the dielectric material to be etched. Preferably about 1/(selectively to the polymer) x T, more preferably about [1/(selectively to the polymer) x T] + 0-50%[1/(selectively to the polymer) x T]. More preferably about 1/(selectively to the polymer) x T, more preferably about [1/(selectively to the polymer) x T] + 30-50%[1/(selectively to the polymer) x T].

Typically, the etch selectivity to polymer with respect to the dielectric material is about 20:1. Assuming an etch selectivity of 20:1, the thickness of the polymer layer should be at least about 1/20 x T. In other words, the thickness of the polymer layer is at least about 1/20 of the thickness of the more vertical portion of the sidewall. Preferably, the thickness of the polymer layer is equal to about 1/20 x T, more preferably, about (1/20 x T) + 0-50% of (1/20 x T). More preferably about 1/(selectively to the polymer) x T, more preferably about [1/(selectively to the polymer) x T] + 30-50%(1/(selectively to the polymer) x T].

In accordance with the invention, the angles of the sidewalls can be changed by adjusting the etch parameters. This enables a smooth transition between the angles of taper, resulting in excellent metal filling of the tapered opening. The exact degree and extent of the taper can be readily tailored by changing the etch parameters, such as time of etch, etch gas ratio, chamber pressure, temperature, magnetic fields in the chamber and/or substrate backside pressure.

A smooth transition between the angles of taper result in excellent metal filling of the tapered opening. The exact degree and extent of the taper can be readily tailored by changing the etch time for the particular etch so as to obtain excellent metal filling of the etched opening.

The following examples illustrate the present process for etching openings in a dielectric layer having a variable taper. However, the invention is not to be limited to the details described therein.

### Example 1

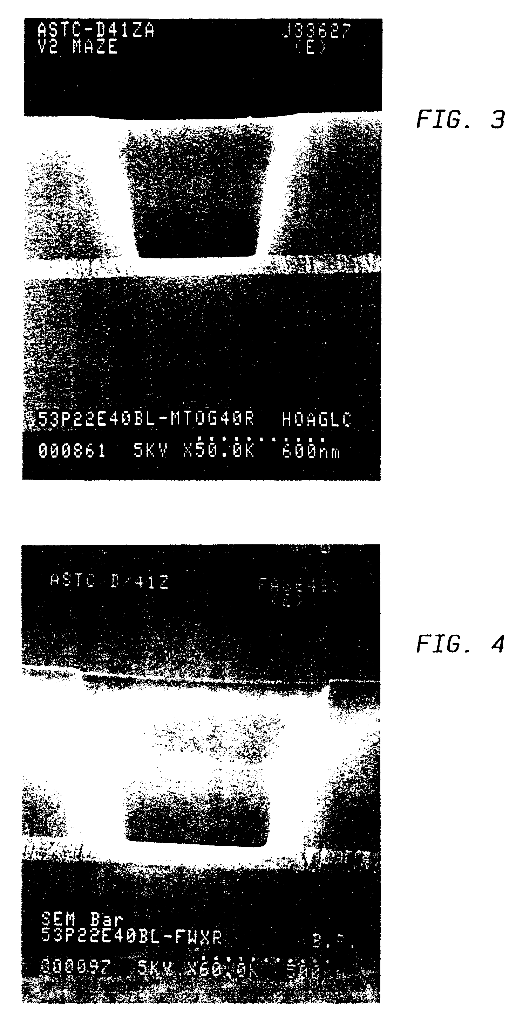

Using a commercially available plasma etch chamber having a wall temperature of 35°C and a cathode support temperature of 20°C, a via was made in a silicon oxide layer deposited over a titanium nitride (TiN) layer, as shown in Fig. 3 under the following conditions:
- Pressure: 300 millitorr (mTorr)
- Helium backside pressure: 8 torr
- Power: 900 watts
- Magnetic field: 80 gauss

A tapered opening was made in a silicon oxide layer in a first step by passing 100 sccm of CHF₃ and 20 sccm of argon into the chamber for 90 seconds. The resultant sidewall taper was about 69° and the opening was about 980 micrometers in diameter.

The gas flow was then changed to 30 sccm CHF₃ and 100 sccm argon and etching was continued in a second step for another 90 seconds. The resultant sidewall taper was about 80° and the opening at the bottom of the via was about 610 micrometers in diameter. Fig. 3 is a photomicrograph of the resultant tapered opening. The tapered sidewalls are smooth, and no undercutting is seen at the substrate.

### Example 2

Using the process conditions as in Example 1, the first step was continued for 120 seconds, forming an opening of about 1000 micrometers in diameter whose sidewall taper angle was about 67°. The second etching step was continued for 60 seconds at a pressure of 100 mTorr instead of 300mTorr. The second step created an opening at the bottom of the via that is about 600 micrometers in diameter and having a sidewall taper angle of about 81°. Fig. 4 is a photomicrograph of the resultant opening. Again, a smooth transition between the initial etch angle and the second etch angle was obtained. No undercutting is apparent.

Thus by varying only two parameters, the time of etching and the proportions of the etch gases, the shape of the sidewall opening can be changed at will, to form different size openings with different angles of taper. An even smoother sidewall taper can be made by gradually changing the proportions of the etch gases. By further varying other parameters, such as pressure, power, magnetic field and the like, an almost infinite variety of sidewall tapers and shapes can be obtained in accordance with the invention.

The choice of etch gases in the Examples was made to achieve a high selectivity of etch between silicon oxide and a barrier layer of TiN at the bottom of the via. However, other fluorine-containing etch gas compositions for silicon oxide are well known and can be substituted depending on the nature of the materials encountered, such as the material of the underlying layer, and the selectivity desired.

Another advantage of the present process is when it is used to etch vias in a silicon oxide layer that has been chemically-mechanically polished (CMP process). This type of polishing is used to planarize the silicon oxide layer, particularly when deposited over topographical features such as metal lines. While effective, CMP does not provide a completely planar silicon oxide layer upon which to build a second layer of devices. Thus when vias are etched through a silicon oxide layer having a variable thickness using a single etch step process, the dimensions of the via near the bottom surface of the silicon oxide layer will vary as well.

Fig. 5 illustrates what happens during a single step etch process through a silicon oxide layer 100 having a variable thickness (the dashes lines in the openings 104 show the original thickness of the silicon oxide layer 100. After the etch, all of the openings 104 are formed with a predetermined angle of taper. Thus openings 104 formed through a thicker portion 102 of the silicon oxide layer 100 have a smaller dimension at the substrate than openings formed through a thinner portion 103 of the silicon oxide layer, although the top portion of the openings have dimensions which are about the same. This occurs because of polymer formation at the top of the openings. However, the deeper the etch required, the narrower the dimension of the opening formed at the interface of the silicon oxide and the underlying substrate. Any misalignment, particularly of the smaller openings, with the underlying contact layers can result in a missed electrical connection.

However, in accordance with the present process, the upper portion of all of the vias are etched in the first step to a predetermined depth in the silicon oxide layer. These openings are all about the same dimension. The second etch step provides a straight walled, nearly vertical sidewall opening. Thus the openings at the bottom of the vias will also all be about the same size, regardless of the thickness of the silicon oxide layer. Only the total depth of the openings will be different.

Although the invention has been described in terms of specific embodiments, various changes to the etch gases, dimensions and taper of the openings and the like can be made as will be known to one skilled in the art, and are meant to be included herein. The invention is only to be limited by the scope of the claims appended hereto.

## Claims

1. A method of plasma etching via openings in a dielectric silicon oxide layer in a single plasma etch chamber comprising
varying the reaction conditions during etching to vary the taper of the sidewall of the etched openings.

2. A method according to claim 1 wherein the etch gases are a mixture of a fluorine-containing gas and argon.

3. A method according to claim 1 wherein the initial etch produces a tapered profile of the sidewalls by depositing a polymer on the sidewalls, and continuing to etch to form straight walled, vertical openings.

4. A method according to claim 1 wherein the fluorine-containing gas is CHF₃.

5. A method for etching via openings in a dielectric silicon oxide layer in a single plasma etch chamber comprising
plasma etching a tapered opening partially through the silicon oxide layer by depositing an increasing amount of polymer on the sidewalls of the opening as etching is continued, and
anisotropically plasma etching straight-walled vertical openings in the remainder of the silicon oxide layer.

6. A method according to claim 5 wherein the plasma is formed from a fluorine-containing gas and argon.

7. A method according to claim 6 wherein the taper of the sidewall is changed by changing the relative proportions of the etch gases.

8. A method according to claim 6 wherein said fluorocarbon-containing etch gas is CHF₃.

9. A method according to claim 5 wherein said silicon oxide layer is of varying thickness.
